(19) Europäisches Patentamt
European Patent Office
Office européen des brevets

(11) **EP 1 012 885 B1**

(12) **EUROPÄISCHE PATENTSCHRIFT**

(45) Veröffentlichungstag und Bekanntmachung des Hinweises auf die Patenterteilung:
**02.05.2007 Patentblatt 2007/18**

(21) Anmeldenummer: **98949872.0**

(22) Anmeldetag: **05.08.1998**

(51) Int Cl.:
*H01L 29/861* (2006.01)     *G01N 27/407* (2006.01)

(86) Internationale Anmeldenummer:
**PCT/DE1998/002292**

(87) Internationale Veröffentlichungsnummer:
**WO 1999/008327 (18.02.1999 Gazette 1999/07)**

(54) **BAUELEMENT MIT GLEICHRICHTUNGSFUNKTION MIT HILFE VON LADUNGSTRANSPORT DURCH IONEN**

COMPONENT WITH RECTIFYING FUNCTION, FULFILLED BY MEANS OF CHARGE TRANSPORT BY IONS

COMPOSANT A FONCTION DE REDRESSEMENT DE COURANT A L'AIDE DU TRANSPORT DE CHARGE PAR DES IONS

(84) Benannte Vertragsstaaten:
**AT BE CH CY DE DK ES FI FR GB GR IE IT LI LU MC NL PT SE**

(30) Priorität: **06.08.1997 DE 19733921**

(43) Veröffentlichungstag der Anmeldung:
**28.06.2000 Patentblatt 2000/26**

(73) Patentinhaber: **Forschungszentrum Jülich GmbH 52425 Jülich (DE)**

(72) Erfinder:
• **KEHR, Klaus, W.**
  **D-52351 Düren (DE)**
• **MUSSAWISADE, Kiaresch**
  **D-51145 Köln (DE)**
• **WICHMANN, Thomas**
  **D-50968 Köln (DE)**
• **POPPE, Ulrich**
  **D-52349 Düren (DE)**

(56) Entgegenhaltungen:
**EP-A- 0 105 993**     **EP-A- 0 108 179**
**WO-A-87/02715**     **WO-A-88/04108**

• **SHIMURA T ET AL: "Electrochemical properties of junction between protonic conductor and oxide ion conductor" SOLID STATE IONICS, Bd. 97, Nr. 1-4, 1. Mai 1997, Seite 477-482 XP004126217**

**Beschreibung**

Die Erfindung betrifft ein Bauelement mit Gleichrichtungsfunktion mit Hilfe von Ladungstransport durch Ionen gemäß dem Oberbegriff des Anspruchs 1.

Die Erfindung beinhaltet insbesondere einen Vorschlag für die Entwicklung von Gleichrichtern für Teilchen, die entweder dünne Schichten in Festkörpern oder dünne Membranen benützen.

Als Stand der Technik ist es bekannt, Gleichrichter für Elektronen auf Halbleiterbasis zu bilden. Sie sind wohlbekannt und in den Lehrbüchern über Halbleiterphysik und -technologie beschrieben.

In der Fachliteratur wurden in den letzten Jahren Vorschläge für Gleichrichter für Ionen gemacht, die in Analogie zu den Gleichrichtern für Elektronen auf Halbleiterbasis konzipiert sind. In Laborversuchen konnten Gleichrichtungseffekte nachgewiesen werden.

Aus der Schrift T. Shimura et al., Solid State Ionics 97, Nr. 1-4, (1997), Seiten 477-482 ist ein Bauelement bekannt, welches zwei unterschiedliche Schichten mit unterschiedlichen Ionentransportverhalten nutzt.

Es ist Aufgabe der Erfindung ein Bauelement mit Gleichrichtungsfunktion mit Hilfe von Ladungstransport durch Ionen zu schaffen, bei dem auf andere Weise als in der bekannten Art der Ionentransport erreicht wird.

Die Aufgabe wird gelöst durch ein Bauelement gemäß der Gesamtheit der Merkmale nach Anspruch 1. Weitere zweckmäßige oder vorteilhafte Ausführungsformen finden sich in den auf diesem Ansprüch rückbezogenen Unteransprüchen.

Es wurde folgendes erkannt:

Das erfindungsgemäß vorgeschlagene Bauelement mit Gleichrichterfunktion beruht auf anderen Prinzipien als die als bekannt beschriebenen, oben erwähnten Gleichrichter für Ionen. Die Basis für das erfindungsgemäße Bauelement bildet eine exakte Theorie der nichtlinearen Mobilität von Teilchen in Potentialen ohne Inversionssymmetrie. Das erfindungsgemäße Bauelement läßt sich aber ohne diese mathematische Beschreibung darstellen.

Es wird die Mobilität der Ionen/Teilchen aufgrund von atomaren Hüpfprozessen von Potentialminimum zu Potentialminimum betrachtet. Das Potential für die Teilchen soll nun die Form einer Treppenstufe haben, wobei von der letzten Stufe aus ein scharfer Abfall auf das Ausgangsniveau erfolgt. Die Mobilität von Teilchen bei dem Hüpfprozeß unter dem Einfluß einer Kraft ist für kleine Kräfte in beiden Richtungen gleich (dies würde dem ohmschen Bereich beim elektrischen Transport entsprechen). Für sehr starke Kräfte in einer Richtung wird die Mobilität durch das Inverse des Mittels der inversen Sprungraten in die entsprechende Richtung bestimmt. Das Mittel von inversen Sprungraten, die alle gleich sind ("'Treppe aufwärts'") ist viel kleiner als das Mittel der Inversen einer sehr kleinen und mehreren großen Sprungraten ("'Treppe abwärts'"). Folglich ist die Mobilität als Inverse dieser beiden Mittel unter dem Einfluß einer starken Kraft groß treppauf und klein in der Richtung treppab. Die hier gegebene Erklärung bezieht sich auf eindimensionale Potentiale, die gegebenenfalls auch in Kanälen in Membranen realisierbar sind. Sie lassen sich aber übertragen auf dreidimensionale Schichtstrukturen, wenn die Schichten in den Richtungen senkrecht zur Bewegungsrichtung gleichförmig sind.

Bezogen auf das Schutzbegehren wird im Detail folgendes ausgeführt:

Es wurde zur Lösung der Aufgabe gemäß Patentanspruch 1 gefunden, das erfindungsgemäße Bauelement mit einem Schichtpaket aus mindestens drei verschiedenen Schichten, die aufeinanderfolgend einen asymmetrischen Verlauf des Energieniveaus aufweisen, sowie ein an dieses Schichtpaket angelegtes elektrisches Feld auszubilden.

Vorteilhafterweise kann dabei das erfindungsgemäße Bauelement gemäß Patentanspruch 2 eine.Mehrzahl aufeinanderfolgender Schichtpakete aufweisen.

Dabei können in besonders vorteilhafter Weise beim erfindungsgemäßen Bauelement nach Patentanspruch 3 eine oder mehrere Schichten des Schichtpakets, insbesondere alle Schichten aus einer Monolage aufgebaut sein.

In Ausbildung der Erfindung gemäß Patentanspruch 4 weist das erfindungsgemäße Bauelement sehr vorteilhaft einen derart ausgebildeten, asymmetrischen Energieniveauverlauf auf, daß in den aufeinanderfolgenden Schichten in der jeweiligen Schicht das Energieniveau den Wert des Energieniveaus der vorangegangenen Schicht nicht unterschreitet, insbesondere von Schicht zu Schicht im Wert zunehmend ausgebildet ist. Auf diese Weise wird eine Gleichrichtfunktion positiv begünstigt.

Gemäß Patentanspruch 5 kann das erfindungsgemäße Bauelement zur Bildung des Schichtpakets halbleitendes Material aufweisen. Es ist jedoch anderes Material zur Bildung des Schichtpakets oder deren Schichten vorstellbar.

Ausführungsbeispiele

Die oben geschilderten, erfindungsgemäßen Potentiale werden durch das Auftragen von mono-atomaren Schichten unterschiedlicher Atomsorten realisiert. Dabei kann es zweckmäßig oder sogar vorteilhaft sein, in Abhängigkeit der Potentialstruktur konkreter Materialien eine auf die gewählten Randbedingungen entsprechend optimierte Auswahl der Materialien zu treffen. Eine andere vorteilhafte Ausbildung des erfindungsgemäßen Bauelements ist durch die Bildung von Kanälen in geeigneten Membranen gegeben.

Das erfindungsgemäße Bauelement mit der vorgeschlagenen Gleichrichterfunktion kann im Bereich der Sensortechnik Anwendung finden. Dabei werden bestimmte Teilchen durch eine Sperrschicht getrieben werden, die sie dann nicht mehr in umgekehrter Richtung überwinden könnten. Vorstellbar sind dabei erfinsdungsgemäß ausgebildete Bauelemente mit Schalteffekten durch zeitliche Änderungen der Kräfte. In Abhängigkeit der Bildung der Schichtstrukturen mit entsprechender lateraler Ausdehnung ist es dabei vorstellbar, auch größere Mengen von Ionen / Teilchen zu transportieren.

Die Erfindung beinhaltet Gleichrichtungseffekte für Ionen, in Schichtstrukturen oder Membranen, die aus der Benutzung von nicht inversionssymmetrischen Potentialverläufen herrühren, sowie die Verwendung von relativ starken Kräften auf die Ionen, derart, daß man im nichtlinearen Bereich der Beweglichkeiten der Ionen, arbeitet.

Gleichförmige Schichtstrukturen lassen sich zum Beispiel mittels Molekularstrahlepitaxie(MBE)-Techniken herstellen.

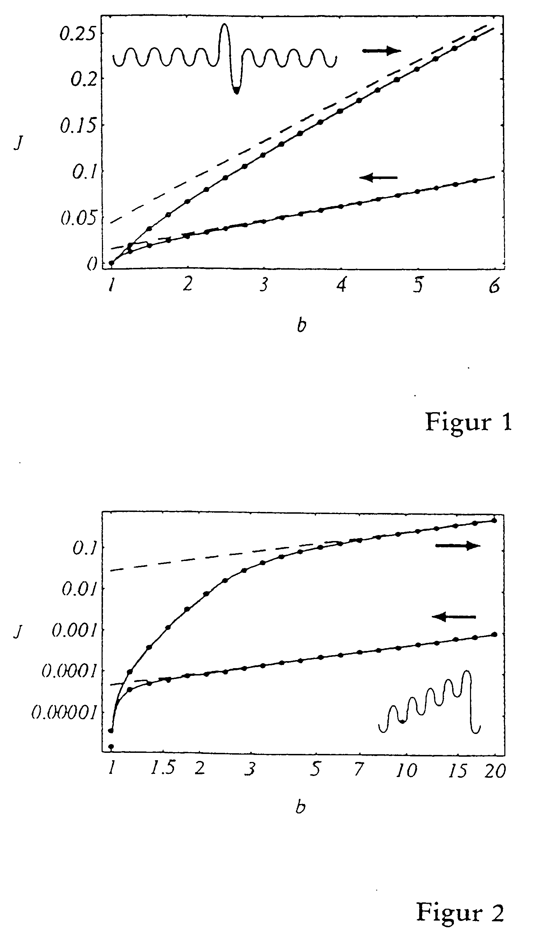

In der Figur 1 ist in einem Modell mit Schwoebel Barrieren mit N = 10 Plätzen der Teilchenstrom J als Funktion des Bias $b$ dargestellt (siehe Einsatz). Die relativen Sprungraten nach rechts sind $e^{-2}$ an der Barriere und aus der Haftstelle heraus, die Rate aus der Haftstelle nach links ist $e^{-4}$. Die Punkte zeigen Simulationen, die vollen Linien die vollständige Theorie und die gestrichelten Linien die asymptotische Theorie.

In der Figur 2 ist der Teilchenstrom J als Funktion des Bias b in einem Treppenstufen-Modell mit N = 5 Plätzen gezeigt. Die relativen Sprungraten haben einen Wert von $e^{-2}$ nach rechts, die relative Sprungrate nach links über die Barriere beträgt $e^{-10}$. Die Punkte zeigen Simulationen, die vollen Linien die vollständige Theorie und die gestrichelten Linien die asymptotische Theorie.

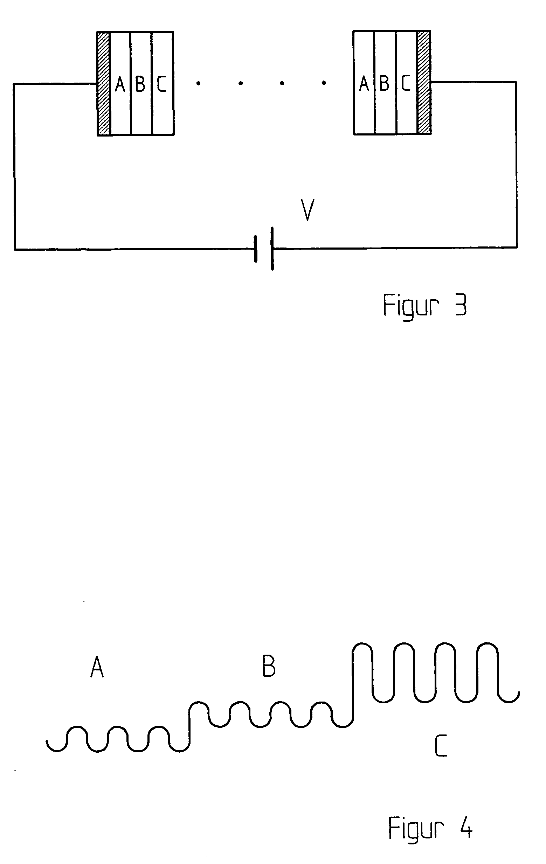

Das erfindungsgemäße Bauelement kann aus Festkörperschichten und Elektroden aufgebaut sein. Als Materialklasse für die Festkörperschichten können auch alle Festkörpermaterialien in Frage kommen, die auch für Brennstoffzellen diskutiert werden, insbesondere Perowskite. Wesentlich dabei ist, daß es sich um elektronische Isolatoren handeln muß. Die Transportströme sind die der Ionen, insbesondere Wasserstoff (H) und Sauerstoff (O). Das Bauelement ist in der Figur 3 an Hand einer Prinzipskizze wie folgt aufgebaut:

Es folgen sich periodisch wiederholende Schichtenfolgen mit drei verschiedenen Schichten A, B, und C, deren Eigenschaften unten besprochen werden. Im Rahmen der Erfindung kann es genügen, daß eine einzige Schichtfolge gewählt wird. Praktische Erwägungen können allerdings mehrere Schichtfolgen nahelegen und sogar vorteilhaft sein. Die Dicke der einzelnen Schichten A, B und C sollte jeweils mindestens einige atomare Monolagen betragen. Solche Schichten lassen sich zum Beispiel durch MBE-Techniken oder durch Sputtern herstellen. Die Festlegung der Schichtdicke erfordert Untersuchungen zur Optimierung des angestrebten Bauelements.

Über die Elektroden wird eine Spannung V angelegt. Die Elektroden bestehen aus einem porösen Material, das für die betreffende Ionensorten durchlässig ist, wie z.B. poröses Platin. Solche Elektroden sind zum Beispiel bekannt aus dem Bereich der Brennstoffzellentechnologie. Die Felder können in einem Bereich bis zu 0.05 V(nm)$^{-1}$ liegen.

Wesentlich für die angestrebte Gleichrichtungsfunktion des Bauelementes ist ein Potentialverlauf für die betreffenden Ionen in der in der Figur 4 dargestellten prinzipiellen Form, in Richtung senkrecht zu den Schichten A, B, und C aus der Figur 3.

Die Potentialmulden entsprechen den Gleichgewichtsenergien der Ionen, während die Potentialberge Barrieren für die Diffusionssprünge darstellen. Es ist bekannt, daß die Mulden in verschiedenen Materialien verschiedene Tiefen haben. Als konkrete Materialien seien beispielhaft die Protonenleiter $SrTiO_3$, $SrCeO_3$, und $SrZrO_3$ genannt, die z.B. mit $Y_2O_3$ dotiert werden und dann Wasserdampf aufnehmen können, der in Form von (OH)-Ionen eingebaut wird. Die Lösungswärme für Wasserdampf variiert zwischen -2 eV im ersten und -0.5 eV im dritten System; sie ist ein Mass für die Tiefe der Potentialmulden. Die Diffusionsbarrieren variieren zwischen etwa 0.6 eV (erstes und zweites System) und 1.2 eV (drittes System). Die Gleichrichtungseffekte treten auf, wenn eine erfindungsgemäße Schichtenfolge aus diesen drei Materialien aufgebaut wird. Diese Materialen sind aber hier nur beispielhaft für viele andere Kombinationen genannt.

Eine mögliche Anwendung des Bauelementes wäre ein löschbares, nichtflüchtiges Speicherelement. Der Zustand "0" wäre der Zustand, wo sich die Ionen auf der einen Seite des Kondensators befinden, der Zustand "1" der, wo sie sich auf der anderen Seite befinden. Der Vorteil der Gleichrichtungsfunktion wäre der, daß sich die Information mit relativ kleiner Spannung einschreiben läßt, während zum Löschen eine entgegengesetzte, höhere Spannung notwendig wäre.

Durch folgende Informationen wird die Erfindung und das erfindungsgemäße Bauelement näher erläutert:

Die Bewegung von Teilchen in nichtsymmetrischen Potentialen unter dem Einfluss von stochastischen Kräften ist aus verschiedenen Gründen von grossem aktuellen Interesse. Ein Problem ist ein Verständnis der Bedingungen, unter denen gerichtete Bewegung von Teilchen auftreten kann. Offensichtlich gibt es eine Verbindung dieses Problems mit dem zweiten Hauptsatz der Thermodynamik [1, 2]. Zusätzlich gibt es interessante Beziehungen dieses Modells zu biologischen Systemen [2-8] oder zu Oberflächen-Diffusionsproblemen [9, 10]. Es besteht Übereinstimmung darüber, dass ein Teilchen, welches in einem statischen nichtsymmetrischen Potential ohne Bias unter dem Einfluss von thermischem Rauschen steht, sich nicht gleichförmig in eine Richtung bewegen wird. In der Gegenwart von fluktuierenden externen Kräften mit genügend langen Korrelationszeiten kann jedoch gerichtete Bewegung auftreten, das heisst, solche Potentiale zeigen Gleichrichtungseffekte bezüglich der langsam veränderlichen Komponenten der äusseren Kraft. Die meisten der vorhergehenden Arbeiten in diesem Gebiet beruhten auf kontinuierlichen Diffusionsmodellen, die durch Bewegungsgleichungen vom Typ der Langevin-Gleichung definiert sind [2-5,7,8,11-13]. Die offensichtliche Relevanz von solchen Modellen für Transportprobleme auf mikroskopischen Skalen legt jedoch eine Behandlung nahe, die wenigstens im Prinzip eine spezifische mikroskopische Umgebung berücksichtigen kann. Die einfachsten miksokopischen Modelle können als Hüpfmodelle für Teilchen auf linearen Ketten mit diskreten Bindungsplätzen und Potentialbarrieren dazwischen definiert werden.

Von diesem Blickpunkt aus untersuchen wir in dieser Veröffentlichung die Hüpfbewegung von Teilchen in einem eindimensionalen diskreten Modell ohne Inversionssymmetrie unter dem Einfluss eines beliebigen Bias in eine Richtung. Wir werden eine quantitative Beschreibung der Gleichrichtungseffekte geben, die in dem Bereich der nichtlinearen Antwort auftreten können. Gleichrichtungseffekte aus einem Ratengleichungsmodell für Transport durch Kanäle in biologischen Membranen, der durch Träger vermittelt wird, sind schon früher diskutiert worden [14]. Wir behandeln hier das Hüpfen von Teilchen in einer beliebigen Folge von Barrieren und Haftstellen, mit periodischen Randbedingungen. Deshalb sind unsere Rechnungen auch gültig für periodische Wiederholungen von Potentialstrukturen ohne Inversionssymmetrie. Wir betonen, dass unsere Ableitungen eine mikroskopische Beschreibung der Gleichrichtungseffekte bei der Hüpfbewegung durch nichtsymmetrische Potentiale geben. Mögliche Anwendungen unseres Modells werden am Ende dieser Veröffentlichung skizziert.

Wir betrachten eine Kette, die aus N + 1 Plätzen $l = 0,...,N$ besteht, mit Platzenergien $E_l$, wobei wir annehmen dass $E_0 = E_N$. In der stationären Situation ist der Strom zwischen Platz $l$ und $l + 1$ durch die Besetzungswahrscheinlichen $P_l$ gegeben als

$$J_l = \Gamma_{l+1,l} e^{K/2} P_l - \Gamma_{l.l+1} e^{-K/2} P_{l+1} \, . \qquad (1)$$

$\Gamma_{l+1,l}$ ist die Sprungrate für einen Übergang von Platz $l$ zum Platz $l + 1$, die mit dem Bias-Faktor $e^{K/2}$ multipliziert ist. Die Rate für den umgekehrten Sprung $\Gamma_{l,l+1}$ ist mit dem inversen Bias-Faktor multipliziert. Es wird angenommen, dass ein Gleichgewichtszustand existiert im Falle der Abwesenheit eines Bias, $b = 1$. Für den Gleichgewichtszustand gilt die Bedingung des detaillierten Gleichgewichts,

$$\Gamma_{l+1,l} P_l^{eq} = \Gamma_{l.l+1} P_{l+1}^{eq} \qquad (2)$$

mit den Besetzungswahrscheinlichkeiten im Gleichgewicht

$$P_l^{eq} = \exp(-\beta E_l)[\frac{1}{N} \sum_{n=0}^{N-1} \exp(-\beta E_n)]^{-1} \, . \qquad (3)$$

In der stationären Situation muss der Strom zwischen irgendeinem Paar von Nachbarplätzen gleich sein, $J = J_l$ für alle $l$. Wir drücken den Strom durch die Übergangsraten nach rechts aus, $\gamma_l \equiv \Gamma_{l+1,l}$, wobei wir die Bedingung des detaillierten Gleichgewichts (2) benützen, und führen die Zerlegung $P_l = P_l^{eq} h_l$ ein. Wir erhalten

$$J = \gamma_l P_l^{eq} (e^{K/2} h_l - e^{-K/2} h_{l+1}) \, . \qquad (4)$$

Aus dieser Gleichung folgt die Rekursionsrelation

$$h_{l+1} = e^K h_l - \frac{J e^{K/2}}{\gamma_l P_l^{eq}} \, . \qquad (5)$$

Diese Rekursionrelation kann in folgende Form gebracht werden

$$h_l = e^{lK} h_0 - e^{-K/2} J e^{lK} S_l \, , \qquad\qquad (6)$$

wobei

$$S_l = \sum_{n=0}^{l-1} \frac{\exp(-nK)}{\gamma_n P_n^{eq}} \qquad \text{und} \qquad S_0 = 0 \, . \qquad (7)$$

Wir möchten $h_0$ durch $S_N$ eliminieren. Dies kann erreicht werden, indem die Gl. (6) für $l = N$ angeschrieben und nach $h_0$ aufgelöst wird. Man beachte, dass $h_0 \equiv h_N$ als Konsequenz der periodischen Randbedingungen gilt. Durch Einsetzen des Resultates in Gl. (6) und Multiplizieren mit $P_l^{eq}$ erhalten wir

$$h_l P_l^{eq} = P_l^{eq} e^{(l-\frac{1}{2})K} J \big[ \frac{S_N}{1 - \exp(-NK)} - S_l \big] \, . \qquad (8)$$

Gleichung (8) stellt die Wahrscheinlichkeit dar, das Teilchen in der stationären Situation auf Platz $l$ zu finden; diese Grösse muss auf Eins normiert werden. Aus der Normierungsbedingung folgt der Ausdruck für den Strom pro Teilchen

$$J = e^{K/2} \left[ \frac{1}{1 - \exp(-NK)} \sum_{l=0}^{N-1} f_l \sum_{n=0}^{N-1} \frac{1}{\gamma_n f_n} - \sum_{l=1}^{N-1} f_l \sum_{n=0}^{l-1} \frac{1}{\gamma_n f_n} \right]^{-1} \, . \qquad (9)$$

Die Grösse $f_l$ ist definiert durch $f_l \equiv P_l^{eq} e^{lK}$. Der Ausdruck (9) kann als das diskrete Analogon des stationären Stroms betrachtet werden, der von Ambegaokar and Halperin [15] in ihren klassischen Arbeit über ein getriebenes Smoluchowski System hergeleitet wurde.

Ein tranparentere Form für J kann durch Rearrangieren der Summen erreicht werden,

$$J = (e^{NK} - 1) \left[ \sum_{l=0}^{N-1} \frac{Y_l}{\gamma_l \exp(-\beta E_l)} \right]^{-1} \qquad (10)$$

mit

$$Y_l = e^{(N-\frac{1}{2})K} \sum_{n=0}^{l} e^{(n-l)K - \beta E_n} + e^{-K/2} \sum_{n=l+1}^{N-1} e^{(n-l)K - \beta E_n} \qquad (11)$$

wobei der letzte Term Null gesetzt werden muss wenn $l = N - 1$. Gleichung (10) ist das Endresultat der formellen Ableitungen. Man prüft leicht anhand einfacher Beispiele nach, dass die Anordnung der Barrieren- und Platzenergien für die Grösse des resultierenden Stromes im Falle beliebigen Bias relevant ist.

Das wohlbekannte Resultat für den Bereich der linearen Antwort [16, 17] kann leicht aus Gln. (10) und (11) hergeleitet werden,

$$J = K\{\sum_{l=0}^{N-1}[\gamma_l P_l^{eq}]^{-1}\}^{-1}\,. \qquad (12)$$

Als Folge des detaillierten Gleichgewichts, Gl. (2), kann der Strom Gl.(12) auch durch die Übergangsraten nach links ausgedrückt werden. Im Bereich der linearen Antwort sind keine Gleichrichtungseffekte vorhanden, d.h. der Strom (12) wechselt einfach das Vorzeichen, wenn das Vorzeichen von $K$ umgedreht wird. Man beachte auch, dass die Terme unter der Summe beliebig umgeordnet werden können.

Als nächstes betrachten wir den nichtlinearen Transport in dem Barrierenmodell mit konstanten Platzenergien $E_l = 0$, in dem die Übergangsraten symmetrisch sind, $\Gamma_{l+1,l} = \Gamma_{l,l+1}$, vgl. auch G1.(2). Aus (10) und (11) erhalten wir unmittelbar die Gleichung

$$J = 2\sinh(\frac{K}{2}[\sum_{l=0}^{N-1}\gamma_l^{-1}]^{-1}\,. \qquad (13)$$

die zuvor im Zusammenhang mit dem Transport in Systemen mit eingefrorener Unordnung abgeleitet wurde [18]. Offensichtlich können auch in diesem Ausdruck die Beiträge der einzelnen Barrieren umgeordnet werden, was die Abwesenheit von Gleichrichtungseffekten impliziert. Für das Auftreten von Gleichrichtungseffekten werden deshalb Modelle benötigt, die variierende Platzenergien $E_l$ enthalten.

Bevor wir spezielle Fälle von Gleichrichtung diskutieren, finden wir eine Bemerkung bezüglich der Sprungmodelle für den Strom durch Membrankanäle angebracht, die in biologisch motivierten Arbeiten studiert wurden [19, 20, 21]. Die dort benützen Randbedingungen sind verschieden von den hier benützten. In den Arbeiten zum Transport durch Membranen sind die Konzentrationen $P_0$ and $P_N$ auf beiden Seiten der Membran die gegebenen Grössen, was einem chemischen Bias entspricht. In Ref.[21] wurden Sättigungseffekte in den Kanälen mitgenommen, mit der Einschränkung dass höchstens ein Teilchen pro Kanal vorhanden ist, wohingegen in dieser Arbeit der Strom auf genau ein Teilchen pro "Kanal" normiert wurde. Einige formale Ähnlichkeiten zwischen dem Audruck für den Strom in [21] und unseren Resultaten können im Falle grosser Konzentrationen $P_0$ and $P_N$ gefunden werden, wenn jeder Kanal durch ein Teilchen besetzt ist.

Wir wenden uns nun dem Vergleich unserer allgemeinen Formel Gl.(10) und (11) mit numerischen Simulationen zu. Wir untersuchen zuerst das Modell der Teilchendiffusion in einem Potential, das Schwoebel-Barrieren darstellt, die für Diffusion an Oberfläen relevant sind [9, 10]. Das Modell ist in Fig. 1 (siehe Einsatz) dargestellt; es hat keine Inversonssymmetrie. In dieser Abbildung sind Resultate der numerischen Simulation gezeigt, zusammen mit dem analytischen Resultat nach Gl. (10). Man erkennt eine perfekte Übereinstimmung zwischen Theorie und Simulationen.

Man sieht, dass die Ströme linear in dem Bias-Parameter $b \equiv \exp(|K|/2)$ für b >> 1 sind. Diese Verhalten kann leicht aus den Rekursionsrelationen Gl. (1) hergeleitet werden. Wir nehmen einen so starken Bias an, dass wir die gegenläufigen Sprungprozesse vernachlässigen können. Mit dieser Annahme vereinfachen sich die Rekursionsrelationen zu

$$J_l = \gamma_l \exp(K/2)P_l\,. \qquad (14)$$

Wir nehmen $J_l = J$ und lösen die Gleichung nach $P_l$ auf. Normierung der $P_l$ ergibt

$$J = e^{K/2}\left[\sum_{l=0}^{N-1}\gamma_l^{-1}\right]^{-1}\,. \qquad (15)$$

In dem Bereich eines starken Bias ist der Strom duch das Inverse der Summe über die inversen Sprungraten in Richtung des Bias bestimmt. Wenn die Richtung umgekehrt wird, $K < 0$, haben wir

$$J = e^{-K/2} \left[ \sum_{l=0}^{N-1} (\gamma'_l)^{-1} \right]^{-1} \tag{16}$$

wobei $\gamma'_l \equiv \Gamma_{l,l+1}$ die Übergangsraten nach links sind. Die Gleichungen (15) and (16) sind in Fig. 1 durch gestrichelte Linien dargestellt; die vollständige Theorie und die numerischen Resultate nähern sich dem asymptotischen Verhalten an.

Das Resultat für starken Bias legt unmittelbar nahe, dass ein grosses Verhältnis zwischen dem Strom nach rechts und dem nach links durch die Wahl eines Potentials erreicht wird, wie es in dem Einsatz von Fig. 2 gezeigt wird. Die Ströme nach links und nach rechts in einem solchen Modell wurden durch numerische Simulationen bestimmt und in Fig. 2 zusammen mit den vollständigen und asymptotischen Resultaten dargestellt. Es besteht Übereinstimmung der Simulationen mit dem vollständigen Resultat und man erkennt, dass das asymptotische Verhalten für genügend starken Bias erreicht wird.

Die diskrete Natur unseres Modells ermöglicht es uns auch, eine allgemeine Abschätzung des Übergangs-Bias zu geben, jenseits von dem der induzierte Strom zu dem begrenzenden Verhalten getrieben wird, das durch die Gln. (15) und (16) impliziert wird. Man beachte, dass in Figs. 1 and 2 der Übergang zum asymptotischen Verhalten bei grösseren Werten von $b$ für die Bias-Richtung mit dem grösseren Strom erfolgt, und bei kleineren Werten von $b$ für die entgegengesetzte Richtung. Die Korrektur zum asymptotischen Verhalten wird durch Sprungprozesse entlang der Kette bestimmt, bei denen alle bis auf einen Sprung in Bias-Richtung erfolgen. Zieht man alle Möglichkeiten für keinen oder einen Sprung in die dem Bias entgegengesetzte Richtung in Betracht, erhält man den folgenden Strom für $K > 0$

$$J = e^{K/2} \left[ \sum_{l=0}^{N-1} \frac{1}{\gamma_l} + e^{-K} \sum_{l=0}^{N-1} \frac{\gamma'_{l+1}}{\gamma_l \gamma_{l+1}} \right]^{-1} \tag{17}$$

wobei die $\gamma_l$, $\gamma'_l$ wie oben definiert sind. Die entsprechende Formel für $K < 0$ kann leicht angegeben werden. Gleichung (17) sagt Bias-Werte voraus, bei denen der Strom 90 % des asymptotischen Stroms beträgt: für das Beispiel von Fig. 1 $b = 3$ (Strom nach rechts), $b = 1.48$ (Strom nach links), und für das Beispiel von Fig. 2 $b = 7.31$ (Strom nach rechts), $b = 1.53$ (Strom nach links). Die Abbildungen verifizieren die Vorhersagen.

Zusammenfassend können wir sagen, dass wir eine mikroskopische Beschreibung von Gleichrichtungseffekten bei der Hüpfbewegung von Teilchen durch nichtsymmetrische Potentiale unter dem Einfluss von starkem Bias gaben. Die Verbindung unserer Ableitungen zum Teilchentransport durch Kanäle in Membranen wurde schon erwähnt. Wir weisen darauf hin, dass die Anwendbarkeit dieser Untersuchung nicht auf lineare Systeme, wie z.B. Kanäle mit nichtsymmetrischen Potentialen, beschränkt ist. Die Resultate können auch auf zwei- und dreidimensionale Systme ausgedehnt werden, zum Beispiel auf gestufte Oberflächen oder auf geschichtete Systeme. Wenn die zugrundeliegende Struktur ein unsymmetrisches Potential in $x$-Richtung, und periodische, gleichförmige Potentiale in $y$- und $z$-Richtung hat, können die Resultate direkt angewandt werden. Der Grund dafür ist, dass die Sprungbewegung von Teilchen in diese Richtungen unabhängig von der x-Richtung ist. Wenn ein Bias in die $x$-Richtung angewandt wird, wird der Strom dann die oben diskutierte nichtlineare Abhängigkeit zeigen, während in die beiden anderen Richtungen nur Diffusion auftritt. Die Situation würde völlig verschieden sein, wenn in der Struktur Defekte vorhanden wären. Auch der Einfluss von vielen Teilchen, die im Wettbewerb um die Besetzung der Plätz stehen, ist nicht bekannt. Siehe aber in diesem Zusammenhang [22, 23], wo schon die Bewegung von vielen Teilchen in nichtlinearen Potentialen betrachtet wird.

**Literatur**

[1] R. P. Feynman, R. B. Leighton, and M. Sands, *The Feynman Lectures* in *Physics* (Addison Wesley, Reading, MA, 1966), Vol. 1, Chap. 46.

[2] M. O. Magnasco, Phys. Rev. Lett. **71**, 1477 (1993).

[3] R. D. Astumian and M. Bier, Phys. Rev. Lett. **72**, 1766 (1994).

[4] J. Prost, J. F. Chauwin, L. Peliti, and A. Ajdari, Phys. Rev. Lett. **72**, 2652 (1994).

[5] M. O. Magnasco, Phys. Rev. Lett. **72**, 2656 (1994).

[6] M. M. Millonas and D. R. Chialvo, Phys. Rev. Lett. **76**, 550 (1996).

[7] H. X. Zhou and Y. D. Chen, Phys. Rev. Lett. **77**, 194 (1996).

[8] J. E. Hall, C. A. Mead, and G. Szabo, J. Membrane Biol. **11**, 75 (1973).

[9] G. Ehrlich, F.G. Hudda, J. Chem. Phys. **44**, 1039 (1966).

[10] R. L. Schwoebel, E. J. Shipsey, J. Appl. Phys. **37**, 3682 (1966); R. L. Schwoebel, J. Appl. Phys. **40**, 614 (1969).

[11] C. R. Doering, W. Horsthemke, and J. Riordan, Phys. Rev. Lett. **72**, 2984 (1994).

[12] I. Zapata, R. Bartussek, F. Sols, and P. Hänggi, Phys. Rev. Lett. **77**, 2292 (1996).

[13] G. A. Cecchi and M. O. Magnasco, Phys. Rev. Lett. **76**, 1968 (1996).

[14] G. Stark, Biochimica and Biophysica Acta **298**, 323 (1973).

[15] V. Ambegaokar and B. I. Halperin, Phys. Rev. Lett. **22**, 1364 (1969).

[16] R. Kutner, D. Knödler, P. Pendzig, R. Przenioslo, and W. Dieterich in *"Diffusion Processes: Experiment, Theory, Simulations"* edited by A. Pekalski, Lecture Notes in Physics **438** (Springer, Berlin, 1994), p. 197.

[17] R. Kutner, Physica A **224**, 558 (1996).

[18] R. Biller, Z.Phys.B **55**, 7 (1984).

[19] B. J. Zwolinski, H. Eyring, and C. E. Reese, J. Phys. Chem. **53**, 1426 (1949).

[20] F. H. Johnson, H. Eyring, and M. I. Polissar, *The Kinetic Basis of Molecular Biology,* (Wiley, New York, 1954), Chap. 14.

[21] P. Läuger, Biochimica et Biophysica Acta **311**, 423 (1973).

[22] I. Derenyi and T. Vicsek, Phys. Rev. Lett. **75**, 374 (1995).

[23] F. Marchesoni, Phys. Rev. Lett. **77**, 2364 (1996).

**Patentansprüche**

1. Bauelement mit Gleichrichtungsfunktion mit Hilfe von Ladungstransport durch Ionen, enthaltend :

   - ein Schichtpaket aus wenigstens drei verschiedenen Schichten, wobei diese drei Schichten aufeinanderfolgend einen asymmetrischen Verlauf der Gleichgewichts-Energieniveaus einer Ionensorte aufweisen, und
   - ein an dieses Schichtsystem angelegtes elektrisches Feld.

2. Bauelement nach vorhergehendem Anspruch,
   **gekennzeichnet durch**
   eine Vielzahl aufeinanderfolgender Schichtpakete.

3. Bauelement nach einem der vorhergehenden Ansprüche,

**gekennzeichnet durch**
wenigstens eine aus einer Monolage aufgebauten Schicht.

4. Bauelement nach einem der vorhergehenden Ansprüche,
   **dadurch gekennzeichnet, daß**
   in den aufeinanderfolgenden Schichten eines Schichtpaketes in einer Schicht das Gleichgewichts-Energieniveau den Wert des Gleichgewichts-Energieniveaus der vorangehenden Schicht nicht unterschreitet.

5. Bauelement nach einem der vorhergehenden Ansprüche,
   **dadurch gekennzeichnet, daß**
   das Schichtpaket aus halbleitendem Material besteht.

6. Bauelement nach einem der vorhergehenden Ansprüche,
   **dadurch gekennzeichnet, daß**
   das Schichtpaket wenigstens einen Mischkristall aufweist, der wenigstens zwei Komponenten umfaßt.

7. Bauelement nach vorhergehendem Anspruch, **dadurch gekennzeichnet, daß**
   aufeinanderfolgende Schichten des Schichtpaketes einen zunehmenden Gehalt einer Komponente zur Bildung eines Verlaufs der Gleichgewichts-Energieniveaus im Schichtpaket aufweisen.

**Claims**

1. Component with rectifying function fulfilled by means of charge transport by ions, containing:

   - a layer block consisting of at least three different layers, in which these three layers consecutively have an asymmetric development of the equilibrium energy level of one ion type and
   - an electrical field positioned on this layer system.

2. Component according to the foregoing claim,
   **characterised by**
   a multiplicity of consecutive layer blocks.

3. Component according to one of the foregoing claims
   **characterised by**
   at least one layer composed of a monolayer.

4. Component according to one of the foregoing claims
   **characterised in that**
   in the consecutive layers of a layer block, in one layer the equilibrium energy level does not fall below the value of the equilibrium energy level of the preceding layer.

5. Component according to one of the foregoing claims
   **characterised in that**
   the layer block consists of semi-conductor material.

6. Component according to one of the foregoing claims
   **characterised in that**
   the layer block has at least one mixed crystal, which includes at least two components.

7. Component according to the foregoing claim
   **characterised in that**
   consecutive layers of the layer block have an increasing content of the component for forming a development of the equilibrium energy level in the layer block.

**Revendications**

1. Composant à fonction de redressement au moyen d'un transport de charge par ions, comprenant :

   - un paquet de couches, constitué d'au moins trois différentes couches, ces trois couches présentent successivement une allure asymétrique du niveau d'énergie d'équilibre d'une sorte d'ions, et
   - un champ électrique appliqué sur ce paquet de couches.

2. Composant selon la revendication précédente,
   **caractérisé par** une pluralité de paquets de couches successifs.

3. Composant selon l'une quelconque des revendications précédentes,
   **caractérisé par** au moins une couche constituée par une monocouche.

4. Composant selon l'une quelconque des revendications précédentes,
   **caractérisé en ce que** dans les couches successives d'un paquet de couches, dans une couche, le niveau d'énergie d'équilibre n'est pas inférieur à la valeur du niveau d'énergie d'équilibre de la couche précédente.

5. Composant selon l'une quelconque des revendications précédentes,
   **caractérisé en ce que** le paquet de couches est en matériau semi-conducteur.

6. Composant selon l'une quelconque des revendications précédentes,
   **caractérisé en ce que** le paquet de couches comporte au moins un cristal mixte comprenant au mois deux constituants.

7. Composant selon l'une quelconque des revendications précédentes, **caractérisé en ce que** des couches successives du paquet de couches comportent une teneur croissant d'un constituant pour créer une allure d'un niveau d'énergie d'équilibre dans le paquet de couches.

Figur 1

Figur 2

Figur 3

Figur 4